# EUROPEAN PATENT APPLICATION

(11) **EP 4 658 020 A1**
(43) Date of publication of application: **03.12.2025**
(21) Application number: 24179267.0
(22) Date of filing: 31.05.2024
(51) Int. Cl.: H10D 62/13, H10D 30/01, H10D 64/00, H10D 30/66, H10D 62/10

(54) **FLAT CONTACT TRENCH MOSFET AND MANUFACTURING METHOD THEREOF**

(71) Applicant: Nexperia B.V., 6534 AB Nijmegen (NL)
(72) Inventor: Mrinal, Aryadeep, Hamburg (DE); Kumar, Manoj, 22529 Hamburg (DE); Khaund, Chinmoy, 22529 Hamburg (DE)
(74) Representative: Pjanovic, Ilija

(57) **Abstract**

A flat contact trench MOSFET (210, 220) comprising a plurality of trenches, wherein a mesa between two trenches comprises a half pitch P+ doped flat contact region (212) and a half pitch N+ doped NP junction region (222), and wherein a surface of the half pitch N+ doped NP junction region (222) is level with the half pitch flat contact region (212). Furthermore, semiconductors devices including such flat contact trench MOSFETs and a process of manufacturing such semiconductor devices are presented.

## Description

### Technical field

The present disclosure relates to flat contact semiconductor trench metal-oxide-semiconductor field-effect transistor (MOSFETs), semiconductor devices including such flat contact trench MOSFETs and a method of manufacturing such semiconductor device.

### Background

A flat contact semiconductor typically refers to a semiconductor device where the contact area between the semiconductor material (such as silicon or gallium arsenide) and the metal electrode is planar or flat.

In semiconductor devices, electrical contacts are essential for connecting the semiconductor material to external circuits, enabling the flow of current in and out of the device. These contacts are typically made by depositing metal layers onto the semiconductor surface through techniques such as evaporation or sputtering.

A "flat contact" implies that the metal electrode deposited on the semiconductor surface forms a uniform, flat interface without significant variation in height or topography. This type of contact may be desirable in semiconductor applications because it ensures consistent electrical properties and reliable performance.

Flat contacts are particularly important in devices where precise control of electrical characteristics is required, such as in integrated circuits (ICs), transistors, diodes, and other semiconductor components. They help to minimize contact resistance, ensure good ohmic contact (low resistance), and facilitate uniform current distribution across the semiconductor material.

A trench MOSFET is a type of power MOSFET that features vertically oriented trench structures etched into the silicon substrate. The trenches may be filled with a conductive material, typically polysilicon or metal, which acts as the gate electrode. A trench structure allows for better control of the electric field distribution within the device, resulting in improved performance characteristics compared to traditional planar MOSFETs, especially in high-power applications. A flat contact in a trench MOSFET ensures good electrical contact and may further enhance the performance of the MOSFET.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a flat contact trench MOSFET is presented. The MOSFET may include a plurality of trenches. A mesa between two trenches may include a half pitch P+ doped flat contact region and a half pitch N+ doped NP junction region. A surface of the half pitch N+ doped NP junction region may be level with the half pitch flat contact region.

In an embodiment, an inter layer dielectric (ILD) may be arranged on top of the trenches. The ILD may be partly arranged on top of a trench having half pitch P+ doped flat contact regions on both sides of the trench with the ILD being level with the half pitch P+ doped flat contact region. The ILD may be partly arranged on top of another trench having half pitch N+ doped NP junction regions on both sides of the other trench with the ILD covering the half pitch N+ doped NP junction regions and a gate poly of the other trench and extending above the surface of the half pitch N+ doped NP junction regions.

In an embodiment, an ILD may be arranged on top of the trenches. The ILD may be arranged on top of the gate polys of the trenches with the ILD being level with the half pitch flat contact regions and the half pitch N+ doped NP junction regions.

In an embodiment, an ILD may be arranged on top of the trenches. The ILD may be partly arranged on top of two adjacent trenches having half pitch P+ doped flat contact regions on one side and a full pitch P+ doped flat contact region in between the two adjacent trenches. The ILD may be partly arranged on top of another trench having a half pitch N+ doped NP junction region on at least one side of the other trench with the ILD covering the half pitch N+ doped NP junction region and a gate poly of the other trench and extending above the surface of the half pitch N+ doped NP junction regions.

In an embodiment, an ILD may be arranged on top of the trenches. Two adjacent trenches may have half pitch P+ doped flat contact regions on one side and a full pitch P+ doped flat contact region in between the two adjacent trenches. The ILD may be arranged on top of the gate polys of the trenches with the ILD being level with the half pitch flat contact regions and the half pitch N+ doped NP junction regions.

In an embodiment, one or more top metal layers may be arranged on top of the ILD. The one or more top metal layers preferably include one or more of a layer of Silicide, a layer of Tungsten and a layer of Aluminum-Copper alloy, AICu.

In an embodiment, a trench may be formed in a semiconductor substrate. The trench may include one or more of a gate poly, a gate oxide, an inter poly oxide (IPO), a source poly and a liner oxide .Deeper parts of the trench may be separated by the semiconductor substrate. Upper parts of the trench may be separated by a P doped body junction, the half pitch N+ doped NP junction region and the half pitch flat contact region.

According to an aspect of the present disclosure, a semiconductor device is presented. The semiconductor device may include a plurality of flat contact trench MOSFETs as described above.

In an embodiment, the semiconductor device may include a striped layout of alternating trench stripes and source N-type region (SN) stripes. The semiconductor device may further include contact stripe regions that are arranged orthogonally to the trench stripes and the SN stripes in an orthogonal direction on top of the trench stripes and SN stripes. The contact stripe regions may be arranged such that one contact stripe region covers a trench stripe and about half of two SN stripes directly adjacent to the covered trench stripe. A plurality of contact stripe regions may be arranged side-by-side in the orthogonal direction and divided by in between regions without contact stripe regions. The contact stripe regions and the in between regions my have a similar width in the orthogonal direction. The semiconductor device may include a plurality of side-by-side orthogonally arranged contact stripe regions. Two neighboring side-by-side orthogonally arranged contact stripe regions may be offset in the orthogonal direction by a distance equal to the width of a contact stripe region. Neighboring side-by-side contact stripe regions may be spaced apart in the direction of the trench stripes and SN stripes.

In an embodiment, the semiconductor device may include a striped layout of alternating trench stripes and SN stripes. The semiconductor device may further include contact stripe regions that are arranged orthogonally to the trench stripes and the SN stripes and in an orthogonal direction on top of the trench stripes and SN stripes. The contact stripe regions may be arranged such that one contact stripe region covers a trench stripe and about half of two SN stripes directly adjacent to the covered trench stripe. A plurality of contact stripe regions may be arranged side-by-side in the orthogonal direction and divided by in between regions without contact stripe regions. The contact stripe regions and the in between regions have a similar width in the orthogonal direction. The semiconductor device may include a plurality of side-by-side orthogonally arranged contact stripe regions. Two neighboring side-by-side orthogonally arranged contact stripe regions may be aligned in the orthogonal direction. Neighboring side-by-side contact stripe regions may be spaced apart in the direction of the trench stripes and SN stripes.

In an embodiment, the semiconductor device may include a striped layout of alternating trench stripes and SN stripes. The semiconductor device may further include contact stripe regions that are arranged in the same direction as the trench stripes and the SN stripes on top of the trench stripes and SN stripes. The contact stripe regions may be arranged such that one contact stripe region covers a trench stripe and about half of two SN stripes directly adjacent to the covered trench stripe. A plurality of contact stripe regions may be arranged side-by-side and may be divided by in between regions without contact stripe regions. The contact stripe regions and the in between regions may have a similar width.

In an embodiment, the semiconductor device may include a striped layout of alternating trench stripes and SN stripes. The semiconductor device may further include contact stripe regions that are arranged in the same direction as the trench stripes and the SN stripes on top of the trench stripes and SN stripes. The contact stripe regions may be arranged such that one contact stripe region covers about half of a trench stripe and about half of one SN stripe directly adjacent to the covered trench stripe. A plurality of contact stripe regions may be arranged side-by-side and may be divided by in between regions without contact stripe regions. The contact stripe regions and the in between regions may have a similar width.

In an embodiment, the semiconductor device may include a striped layout of alternating trench stripes and SN stripes. The semiconductor device may further include contact stripe regions that are arranged orthogonally to the trench stripes and the SN stripes in an orthogonal direction on top of the trench stripes and SN stripes. The contact stripe regions may be arranged such that one contact stripe region covers two trench stripes, one intermediate SN stripe and about half of two SN stripes directly adjacent to the covered trench stripes. A plurality of contact stripe regions may be arranged side-by-side in the orthogonal direction and are divided by in between regions without contact stripe regions. The contact stripe regions and the in between regions may have a similar width in the orthogonal direction. The semiconductor device may include a plurality of side-by-side orthogonally arranged contact stripe regions. Two neighboring side-by-side orthogonally arranged contact stripe regions may be offset in the orthogonal direction by a distance equal to the width of a contact stripe region. Neighboring side-by-side contact stripe regions may be spaced apart in the direction of the trench stripes and SN stripes.

According to an aspect of the present disclosure, a process of manufacturing a semiconductor device is presented. The semiconductor device may have one or more of the above described features. The process may include creating a plurality of trenches in an epitaxial layer. The process may further include forming, in a mesa between two trenches, a body region and a source region by implant and diffusion in presence of a mask using half of a pitch width to form the source region in half of the mesa. The process may further include etching an ILD in the direction of a silicon surface. The etching may be performed in presence of a further mask using half of the pitch width to expose the other half of the mesa. The process may further include forming a flat contact region in the other half of the mesa by implanting the other half of the mesa.

In an embodiment, the process may further include, before forming the body region and the source region, creating a gate recess further below a silicon surface. Preferably, a depth of the gate recess is twice or more than twice the thickness of a gate oxide of a trench.

### Brief description of the Drawings

Embodiments of the present disclosure will now be described, by way of example only, with reference to the accompanying schematic drawings in which corresponding reference symbol indicate corresponding parts, in which:
Fig. 1 shows side views of flat contact trench MOSFETs and a top view of an arrangement of such MOSFETs in a semiconductor device, as known in the prior art;
Fig. 2 shows side views of example embodiments of flat contact trench MOSFETs and a top view of an example embodiment of an arrangement of such MOSFETs in a semiconductor device, according to an aspect of the present disclosure;
Figs. 3A-3B show side views of steps in a manufacturing process of a flat contact trench MOSFET, according to an aspect of the present disclosure;
Figs. 4-6 show top views of further example embodiments of arrangements of flat contact trench MOSFETs in a semiconductor device according to an aspect of the present disclosure;
Fig 7A shows side views of further example embodiments of flat contact trench MOSFETs and Fig. 7B shows a top view of an example embodiment of an arrangement of such MOSFETs in a semiconductor device, according to an aspect of the present disclosure;
Figs. 8-9 show top views of further example embodiments of arrangements of flat contact trench MOSFETs in a semiconductor device according to an aspect of the present disclosure; and
Figs. 10-11 show side views of example embodiments of U-shaped MOSFETs.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

In semiconductor manufacturing, "mesa" and "pitch" refer to specific features and dimensions involved in the fabrication of semiconductor devices.

A mesa is a raised structure formed on a semiconductor substrate, typically silicon, during the fabrication process. It may be created by selectively etching away surrounding material to leave behind a raised area with defined boundaries. Mesas are commonly used in the fabrication of various semiconductor devices, including bipolar transistors, field-effect transistors (FETs), and photonic devices such as lasers and photodiodes. The formation of mesas allows for isolation between different regions of a semiconductor device, helping to prevent electrical interference and improve device performance.

Pitch refers to the distance between repetitive features on a semiconductor device, such as transistors, interconnects, or memory cells. Pitch is a critical parameter that directly affects the density of components on a semiconductor chip. Smaller pitch values enable tighter packing of components, leading to higher device density and improved performance. Pitch can be specified in various units, such as micrometers (µm) or nanometers (nm), depending on the scale of the semiconductor fabrication process.

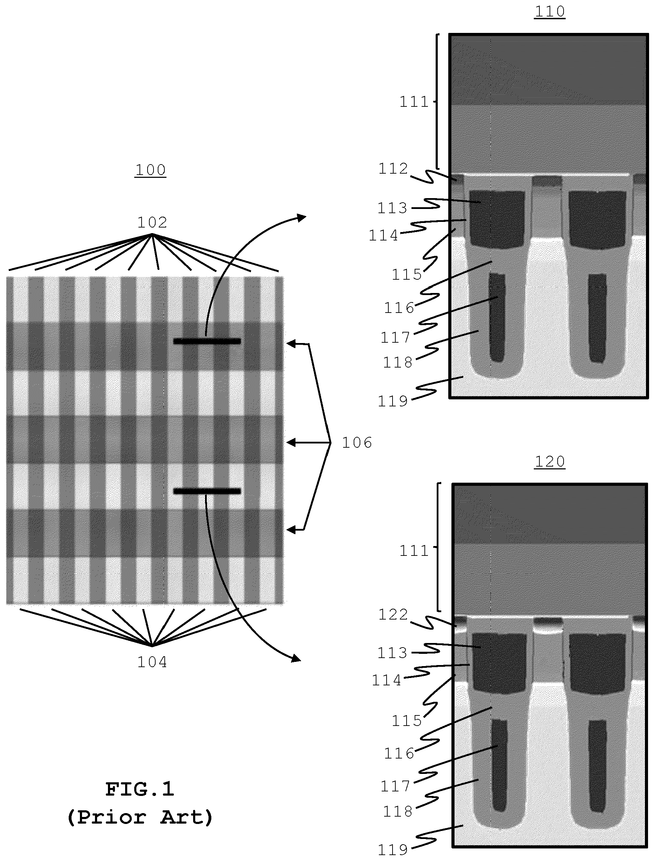

Fig. 1 shows examples of flat contact trench MOSFETs as known in the prior art. The trench MOSFETs may be part of a semiconductor device 100 including a striped layout of alternating trench stripes 102 and SN stripes 104, as shown in the top-down view of the semiconductor device 100 in Fig. 1. Orthogonally to the trench stripes 102 and SN stripes 104, contact stripes 106 are arranged on top of the trench stripes 102 and SN stripes 104. Neighboring contact stripes 106 do not touch, i.e., are spaced apart in the direction of the trench stripes 102 and SN stripes 104. The semiconductor device 100 as shown in Fig. 1 includes trench MOSFETS in a single cell flat contact arrangement.

Generally, trench stripes are narrow, vertically etched features in a semiconductor substrate that penetrate from the surface into the bulk material. Trench stripes generally refer to the areas of the device where the trenches of the MOSFET are located. "SN" typically stands for "Source N-type region". The SN stripes in a trench MOSFET refer to the regions where the source terminals of the transistor connect to the semiconductor substrate or epitaxial layer. The SN stripes carry the current through the device when it is in the on-state. Contact stripes are the areas of the device where metal contacts are formed to provide electrical connections to source. Gate contacts are made into trenches with separate metal link up (not shown in the figures). Drain contacts are at the bottom of the device. These metal contacts are typically made of materials like aluminum or copper and are patterned onto the semiconductor surface using techniques such as photolithography and metal deposition. Contact stripes ensure proper electrical contact between the metal interconnects and the semiconductor regions, enabling the MOSFET to function correctly within an electronic circuit.

In the top-view of the semiconductor device 100, two areas with trenches have been highlighted (black bars) and shown in more detail on the right side of Fig. 1. A first area is located below a contact stripe 106 and is shown in more detail in the side view of a part of trench MOSFET 110. A second area is not located below a contact stripe 106 and is shown in more detail in the side view of a part of trench MOSFET 120.

The part of the trench MOSFET 110 as shown in Fig. 1 includes two trenches each comprising a gate poly 113, a gate oxide 114, an inter poly oxide (IPO) 116, a source poly 117 and a liner oxide 118. The trenches are formed in the semiconductor substrate 119, such as epitaxy layers or an N++/N- substrate. Deeper parts of the trenches (e.g., 116, 117, 118) are separated by the substrate material 119 while the upper parts of the trenches (e.g., 113, 114) are separated by a P doped body junction 115 and a P+ doped flat contact region 112. In this example, the pitch is the distance between the trenches, i.e., including the flat contact region 112. On top of the silicon surface, top metal layers 111 may be deposited allowing the semiconductor device to interconnect with, e.g., a contact stripe 106. In the example of Fig. 1, the metal layers 111 include a layer of Silicide, e.g., TiSi, a layer of Tungsten (W) and a layer of Aluminum-Copper alloy (AlCu).

The part of the trench MOSFET 120 as shown in Fig. 1 is similar to the part of the trench MOSFET 110, except for including an N+ doped NP junction region 122 instead of a P+ doped flat contact region 112. In this example, the pitch is the distance between the trenches, i.e., including the NP junction region 122.

The present disclosure presents an improved flat contact semiconductor trench MOSFET to improve on threshold voltage (VTH) shifts, on-resistance (RDSON) and ruggedness improvements compared to known flat contact trench MOSFET semiconductor devices, such as shown in Fig. 1. VTH refers to the voltage level at which the MOSFET switches from the off state to the on state, or vice versa. RDSON refers to the on-resistance of the MOSFET when it is in its conducting state. Ruggedness refers to the ability of the semiconductor device to withstand and operate reliably under stressful conditions, such as high voltages, high temperatures, current surges, or other environmental factors.

According to an aspect of the present disclosure, the MOSFET semiconductor device may comprise a stripe source implant and flat contact arrangement where about half of the mesa between trenches (i.e., at half of the pitch) is implanted with source implant and the other half of the mesa (i.e., also at half of the pitch) has a flat contact. This advantageously allows to shrink the mesa area between trenches and therefore increases cell density, lower RDSON, lower threshold voltage shifts with and without lithography limitations.

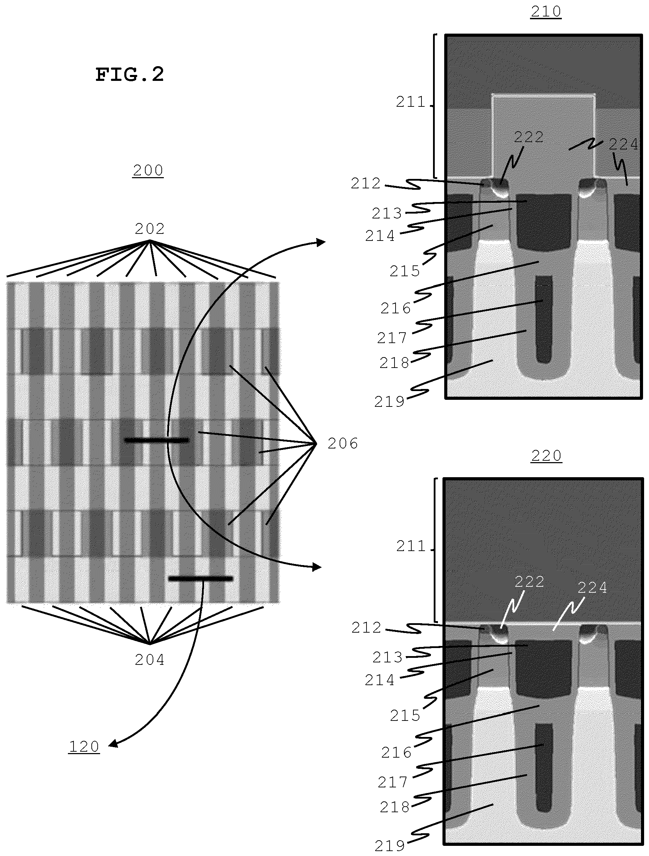

Fig. 2 shows example embodiments of flat contact trench MOSFETs 210, 220 according to an aspect of the present disclosure. The trench MOSFETs 210, 220 may be part of a semiconductor device 200 including a striped layout of alternating trench stripes 202 and SN stripes 204, as shown in the top-down view of the semiconductor device 200 in Fig. 2. Orthogonally to the trench stripes 202 and SN stripes 204, contact stripe regions 206 may be arranged in an orthogonal direction on top of the trench stripes 202 and SN stripes 204.

In the example of Fig. 2, orthogonally arranged to the trench stripes 202 and the SN stripes 204, the contact stripe regions 206 may be arranged such that one contact stripe region 206 covers a trench stripe 202 and about half of two SN stripes 204 directly adjacent to the covered trench stripe 202. A plurality of contact stripe regions 206 may be arranged side-by-side in the orthogonal direction and may be divided by in between regions without contact stripe regions 206, wherein the contact stripe regions 206 and the in between regions have a similar width in the orthogonal direction. The semiconductor device 200 may include a plurality of such side-by-side orthogonally arranged contact stripe regions 206. In the example of Fig. 2, two neighboring side-by-side orthogonally arranged contact stripe regions 206 may be offset in the orthogonal direction by a distance equal to the width of a contact stripe region 206, wherein neighboring side-by-side contact stripe regions 206 do not touch, i.e., are spaced apart in the direction of the trench stripes 202 and SN stripes 204.

In the top-view of the semiconductor device 200, two areas with trenches have been highlighted (black bars). The top area is shown in more detail on the right side of Fig. 2, where two variants 210, 220 of a part of the trench MOSFET according to an aspect of the present disclosure are shown. The bottom area may be similar to the part of the trench MOSFET 120 as described with Fig. 1.

The part of the trench MOSFET 210, 220 as shown in Fig. 2 includes three trenches. Half of the left trench and half of the right trench are shown and a middle trench is shown in full. Each trench may comprise a gate poly 213, a gate oxide 214, an IPO 216, a source poly 217 and a liner oxide 218. The trenches are formed in the semiconductor substrate 219, such as epitaxy layers or an N++/N- substrate. Deeper parts of the trenches (e.g., 216, 217, 218) are separated by the substrate material 219 while the upper parts of the trenches (e.g., 213, 214) may be separated by a P doped body junction 215 and two half pitch regions 212, 222.

The half pitch regions 212, 222 may include a half pitch P+ doped flat contact region 212 and a half pitch N+ doped NP junction region 222. The surface of the half pitch N+ doped NP junction region 222 may be level with the half pitch flat contact region 212.

An inter layer dielectric (ILD) 224 may be deposited on top of the trenches. In the example embodiment of the part of the trench MOSFET 210, the ILD 224 may be deposited on top of the trenches having half pitch P+ doped flat contact regions 212 on both sides of the trench, with the ILD being level with the half pitch P+ doped flat contact region 212. In the trench MOSFET 210, the ILD 224 may further be deposited on top of the trenches having half pitch N+ doped NP junction regions 222 on both sides of the trench, the ILD 224 covering the half pitch N+ doped NP junction regions 222 and gate poly 213 of the trench and extending above the surface of the half pitch N+ doped NP junction regions 222.

In the example embodiment of the part of the trench MOSFET 220, the ILD 224 may be deposited on top of the gate poly 213 of the trenches, with the ILD being level with the half pitch flat contact regions 212 and the half pitch N+ doped NP junction regions 222.

In both variants of the parts of the trench MOSFET 210, 220, on top of the ILD 224 top metal layers 211 may be deposited allowing the semiconductor device to interconnect with, e.g., a contact stripe 206. In the example of Fig. 2, the metal layers 211 may include a layer of Silicide, e.g., TiSi, a layer of Tungsten (W) and/or a layer of AlCu. In the part of the trench MOSFET 210, the metal layer may be deposited to cover the half pitch flat contact regions 212 and the ILD 224.

The semiconductor device 200 as shown in Fig. 2 includes trench MOSFETS 210, 220 in a single cell off-set flat contact arrangement. The half pitch structures 212, 222, i.e., half pitch P+ doped flat contact regions 212 and the half pitch N+ doped NP junction regions 222, in the semiconductor device 200 advantageously provide more uniform distribution of current and reduced current crowding. The single cell off-set flat contact arrangement as shown in the top-view of the semiconductor device 200 of Fig. 2 with its offset square contact stripe regions 206 provides opportunity to choose best possible solution with respect to RDSON and ruggedness. RDSON improvement can be achieved with increased channels at same body pickup coverage.

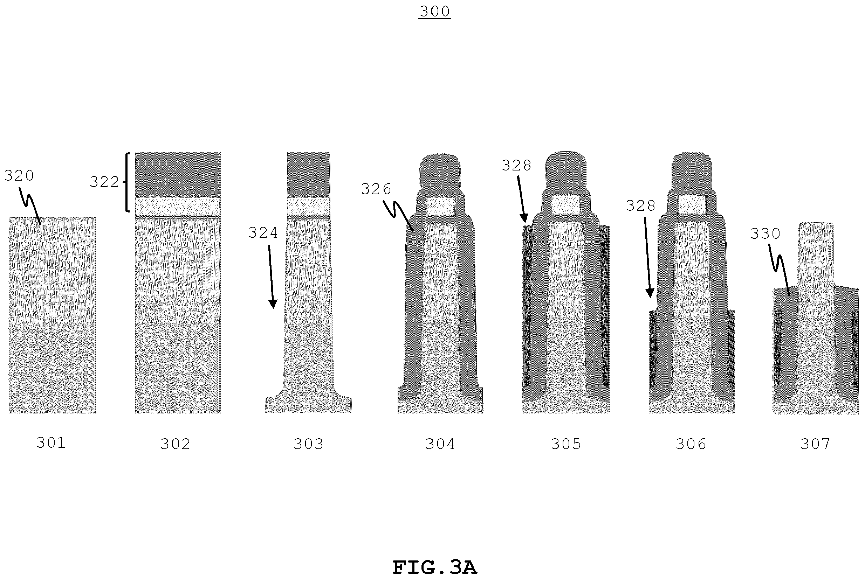

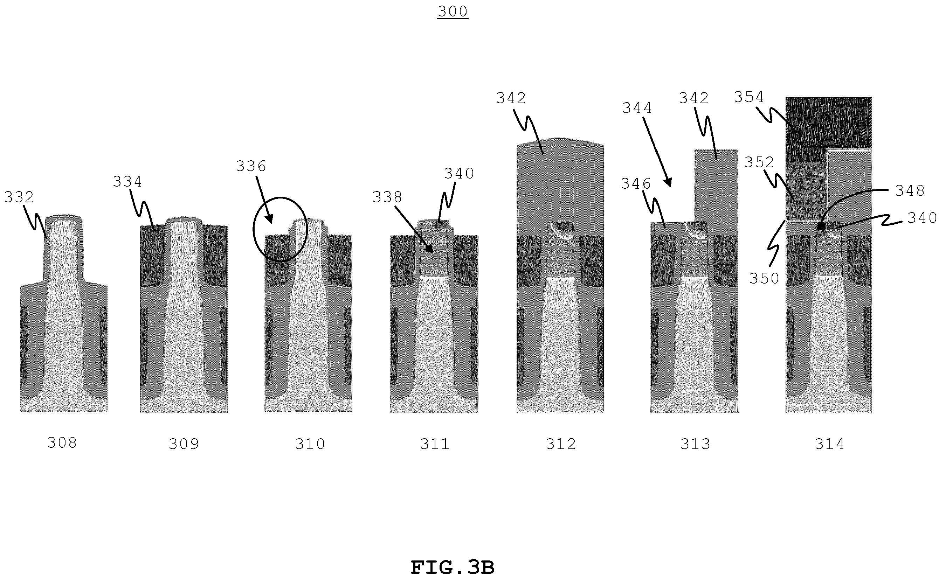

With reference to Figs. 3A and 3B, according to an aspect of the present disclosure, a manufacturing process 300 is presented for manufacturing a semiconductor device, such as the semiconductor device 200 or any of the further example embodiments of semiconductor devices described herein, including flat contact trench MOSFETs comprising half pitch structures such as shown in Fig. 2 in the form of the half pitch P+ doped flat contact regions 212 and the half pitch N+ doped NP junction regions 222.

The manufacturing process 300 may start with providing 301 an epitaxial layer 320 on a substrate. In step 302, a hard mask 322, typically comprising an oxide layer, may be deposited on the epitaxial layer 320. In step 303, a deep trench 324 may be etched using lithography and a trench etch process. In step 304, a liner oxide 326 may be deposited or thermally grown. In step 305, a source poly 328 may be deposited in the trench and in step 306 the source poly 328 may be etched to form the source poly electrode in the trench. In step 307, IPO 330 may be developed by etching the deposited oxide on the wafer. In step 308, a gate oxide 332 may be formed on the side walls of the trench. In step 309, the trench may be filled with doped polysilicon 334 to form the gate of the trench MOSFET.

In step 310, a gate recess 336 may be created further below the silicon surface to enable the half pitch structures to be created. The gate poly, such as the gate poly 213 or the doped polysilicon 334, may thus be recessed deeper than the silicon surface, such as shown in step 310. For example, the depth of the poly recess 336 may be twice or more than twice the thickness of the gate oxide 332. This allows the ILD thickness to be maintained and more than the gate oxide.

In step 311, a body region 338 may be formed by implant and diffusion and a source region 340 may be formed by implant and diffusion in presence of a mask using half of the pitch width to form the source region 340. Thus, in half of the mesa between two trenches the source region 340 may be formed. The half pitch N+ doped NP junction regions 222 are an example of such source region 340. Different from known flat contact trench MOSFETs, such as shown in Fig. 1, the source implant in the solution of the present disclosure, such as the half pitch N+ doped junction NP regions 222 or source region 340, is not a blanket implant in an active area of the MOSFET but may be masked with a critical dimension for half the pitch.

In step 312, ILD 342 may be formed by deposition.

In step 313, the flat contact may be formed by etching the ILD 342 to the silicon surface resulting in removal of the part 344 from the ILD 342 and resulting in the ILD 346, the etching being performed in presence of a mask using half of the pitch width to form the flat contact above the ILD 346 and exposing half of the mesa between two trenches. The etching may be performed using critical dimension etching (CT etching).

In step 314, a flat contact region 348 may be formed by implant on the exposed mesa part between two trenches. Thus, in half of the mesa between two trenches other than the source region 340, the flat contact region 348 may be formed. The half pitch flat contact regions 212 are an example of such flat contact region 348. The contact implant resulting in the contact region 348 is on the silicon surface, it is masked and has a critical dimension for half pitch. Note that the contact implant is not the contact trench in silicon.

Furthermore, in step 314, top metal layers, e.g., a silicide 350, a Tungsten (W) layer 352 and an AICu layer 354, may be formed.

Steps 301-309, 312 and 314 may be performed using any known method. Steps 310, 311 and 313 may be performed in accordance with the present disclosure.

The manufacturing process 300 advantageously allows to shrink the pitch/mesa while keeping the same trench. It further allows to reduce epi resistance while maintaining the drain-to-source breakdown voltage (BVDss). Furthermore, it allows minimal shift in VTH with misalignment. Moreover, it enables improvement in source parasitic resistance (RSP) / RDSON.

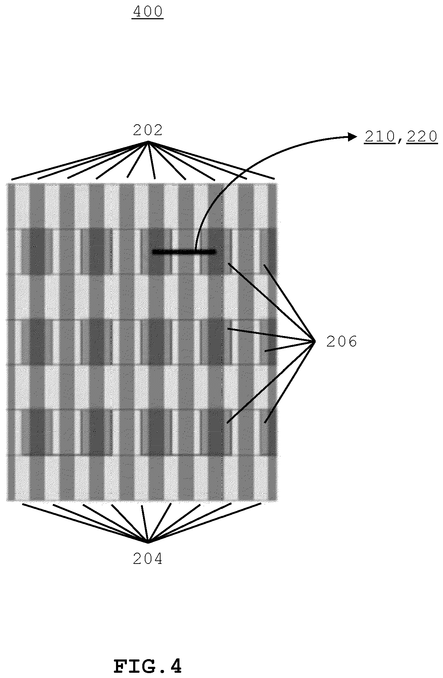

Fig. 4 is a top-view of another example embodiment of a semiconductor device 400 including a striped layout of alternating trench stripes 202 and SN stripes 204. Orthogonally to the trench stripes 202 and SN stripes 204, contact stripe regions 206 may be arranged in an orthogonal direction on top of the trench stripes 202 and SN stripes 204. The semiconductor device 400 is similar to the semiconductor device 200 of Fig. 2, except for the arrangement of two side-by-side orthogonally arranged contact stripe regions 206. The semiconductor device 400 may include a plurality of side-by-side orthogonally arranged contact stripe regions 206, wherein two neighboring side-by-side orthogonally arranged contact stripe regions 206 are aligned in the orthogonal direction, i.e., cover the same trench stripes 202 and SN stripes 204. The highlighted area (black bar) indicates that the trenches at that location may be realized such as the part of the trench MOSFET 210 or the part of the trench MOSFET 220 as shown in Fig. 2. Similar to the semiconductor device 200, the semiconductor device 400 includes trench MOSFETS 210, 220 in a single cell off-set flat contact arrangement having similar advantages as described for the semiconductor device 200.

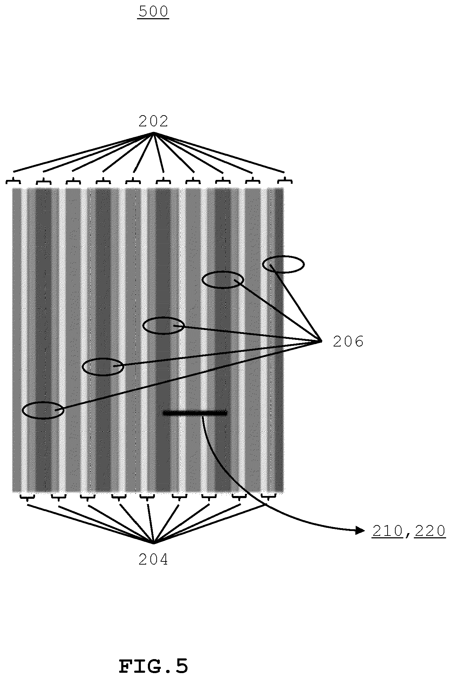

Fig. 5 is a top-view of another example embodiment of a semiconductor device 500 including a striped layout of alternating trench stripes 202 and SN stripes 204. Contact stripe regions 206 may be arranged in the same direction as the trench stripes 202 and SN stripes 204 on top of the trench stripes 202 and SN stripes 204.

In the example of Fig. 5, the contact stripe regions 206 may be arranged such that one contact stripe region 206 covers a trench stripe 202 and about half of two SN stripes 204 directly adjacent to the covered trench stripe 202. A plurality of contact stripe regions 206 may be arranged side-by-side in the orthogonal direction and may be divided by in between regions without contact stripe regions 206, wherein the contact stripe regions 206 and the in between regions have a similar width in the orthogonal direction. The highlighted area (black bar) indicates that the trenches at that location may be realized such as the part of the trench MOSFET 210 or the part of the trench MOSFET 220 as shown in Fig. 2.

The semiconductor device 500 includes trench MOSFETS 210, 220 with half pitch P+ doped flat contact regions 212 and half pitch N+ doped NP junction regions 222. In the semiconductor device 500, the trench MOSFETS 210, 220 are arranged in an asymmetric flat contact stripe arrangement that advantageously enhances the current distribution in both on and off state of the MOSFET.

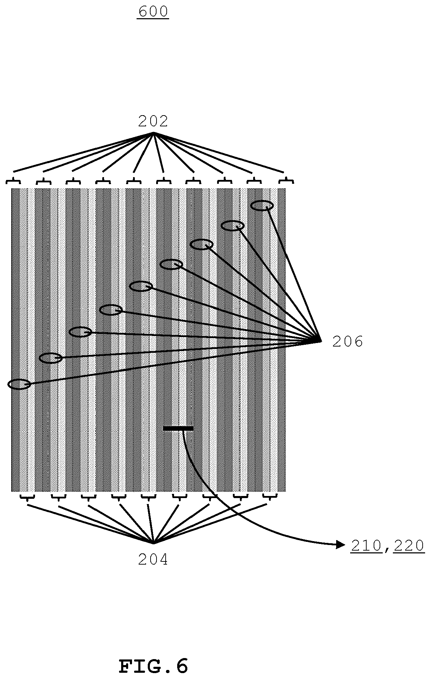

Fig. 6 is a top-view of another example embodiment of a semiconductor device 600 including a striped layout of alternating trench stripes 202 and SN stripes 204. Contact stripe regions 206 may be arranged in the same direction as the trench stripes 202 and SN stripes 204 on top of the trench stripes 202 and SN stripes 204.

In the example of Fig. 6, the contact stripe regions 206 may be arranged such that one contact stripe region 206 covers about half of a trench stripe 202 and about half of one SN stripe 204 directly adjacent to the covered trench stripe 202. A plurality of contact stripe regions 206 may be arranged side-by-side in the orthogonal direction and may be divided by in between regions without contact stripe regions 206, wherein the contact stripe regions 206 and the in between regions have a similar width in the orthogonal direction. The highlighted area (black bar) indicates that the trenches at that location may be realized such as the part of the trench MOSFET 210 or the part of the trench MOSFET 220 as shown in Fig. 2.

The semiconductor device 600 includes trench MOSFETS 210, 220 with half pitch P+ doped flat contact regions 212 and half pitch N+ doped NP junction regions 222. In the semiconductor device 600, the trench MOSFETS 210, 220 are arranged in a flat contact stripe arrangement that advantageously provides an improved current distribution in ruggedness over an orthogonal construction.

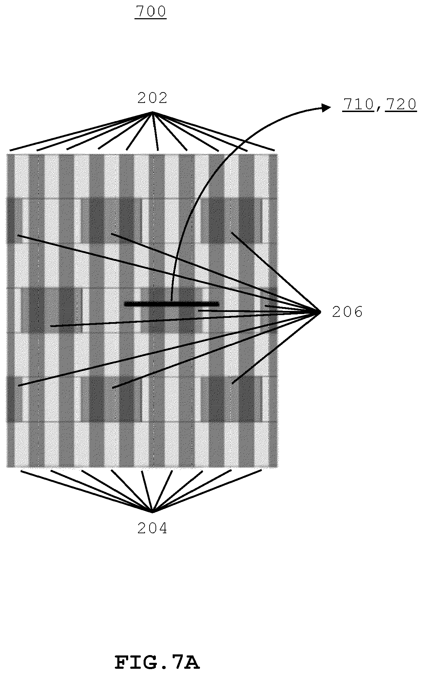

Figs. 7A an 7B show other example embodiments of flat contact trench MOSFETs 710, 720. The trench MOSFETs 710, 720 may be part of a semiconductor device 700 including a striped layout of alternating trench stripes 202 and SN stripes 204, as shown in the top-down view of the semiconductor device 700 in Fig. 7A. Orthogonally to the trench stripes 202 and SN stripes 204, contact stripe regions 206 may be arranged in an orthogonal direction on top of the trench stripes 202 and SN stripes 204.

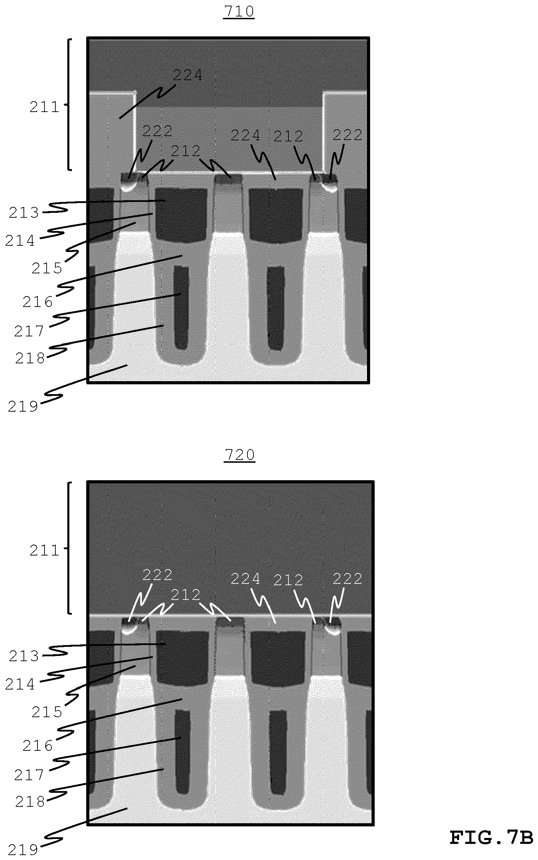

In the example of Fig. 7A, orthogonally arranged to the trench stripes 202 and the SN stripes 204, the contact stripe regions 206 may be arranged such that one contact stripe region 206 covers two trench stripes 202, one intermediate SN stripe 204 and about half of two SN stripes 204 directly adjacent to the covered trench stripes 202. A plurality of contact stripe regions 206 may be arranged side-by-side in the orthogonal direction and may be divided by in between regions without contact stripe regions 206, wherein the contact stripe regions 206 and the in between regions have a similar width in the orthogonal direction. The semiconductor device 700 may include a plurality of such side-by-side orthogonally arranged contact stripe regions 206. In the example of Fig. 7, two neighboring side-by-side orthogonally arranged contact stripe regions 206 may be offset in the orthogonal direction by a distance equal to the width of a contact stripe region 206, wherein neighboring side-by-side contact stripe regions 206 do not touch, i.e., are spaced apart in the direction of the trench stripes 202 and SN stripes 204.

In the top-view of the semiconductor device 700, one area with trenches has been highlighted (black bar) and is shown in more detail in Fig. 7B, where two variants 710, 720 of example embodiments of a part of the trench MOSFET are shown.

The part of the trench MOSFET 710, 720 as shown in Fig. 7B includes four trenches. Half of the left trench and half of the right trench are shown and two trenches are shown in full. Each trench may comprise a gate poly 213, a gate oxide 214, an IPO 216, a source poly 217 and a liner oxide 218. The trenches are formed in the semiconductor substrate 219, such as epitaxy layers or an N++/N- substrate. Deeper parts of the trenches (e.g., 216, 217, 218) are separated by the substrate material 219. The upper parts of two adjacent trenches (e.g., 213, 214) may be separated by a P doped body junction 215 and two half pitch regions 212, 222, i.e., a half pitch P+ doped flat contact region 212 and a half pitch N+ doped NP junction region 222, while the upper parts of two other adjacent trenches may be separated by a P doped body junction 215 and a full pitch P+ doped flat contact region 212. The surface of the half pitch N+ doped NP junction region 222 may be level with the half pitch flat contact region 212.

An inter layer dielectric (ILD) 224 may be deposited on top of the trenches. In the example embodiment of the part of the trench MOSFET 710, the ILD 224 may be deposited on top of two adjacent trenches having half pitch P+ doped flat contact regions 212 on one side of the trench and a full pitch P+ doped flat contact region 212 in between the two trenches, with the ILD being level with the half pitch P+ doped flat contact region 212. In the trench MOSFET 710, the ILD 224 may further be deposited on top of the trenches having half pitch N+ doped NP junction regions 222 on both sides of the trench, the ILD 224 covering the half pitch N+ doped NP junction regions 222 and gate poly 213 of the trench and extending above the surface of the half pitch N+ doped NP junction regions 222.

In the example embodiment of the part of the trench MOSFET 720, the ILD 224 may be deposited on top of the gate poly 213 of the trenches, with the ILD being level with the half pitch flat contact regions 212, the half pitch N+ doped NP junction regions 222 and the full pitch flat contact regions 212.

In both variants of the parts of the trench MOSFET 710, 720, on top of the ILD 224 top metal layers 211 may be deposited allowing the semiconductor device to interconnect with, e.g., a contact stripe 206. In the example of Fig. 7B, the metal layers 211 may include a layer of Silicide, e.g., TiSi, a layer of Tungsten (W) and/or a layer of AlCu. In the part of the trench MOSFET 710, the metal layer may be deposited to cover the half pitch flat contact regions 212 and the ILD 224.

The semiconductor device 700 as shown in Fig. 7A includes trench MOSFETS 710, 720 in a dual cell off-set flat contact arrangement. The half pitch structures 212, 222, i.e., half pitch P+ doped flat contact regions 212 and the half pitch N+ doped NP junction regions 222, in the semiconductor device 700 further creates opportunity to optimize best possible solution with respect to RDSON and ruggedness.

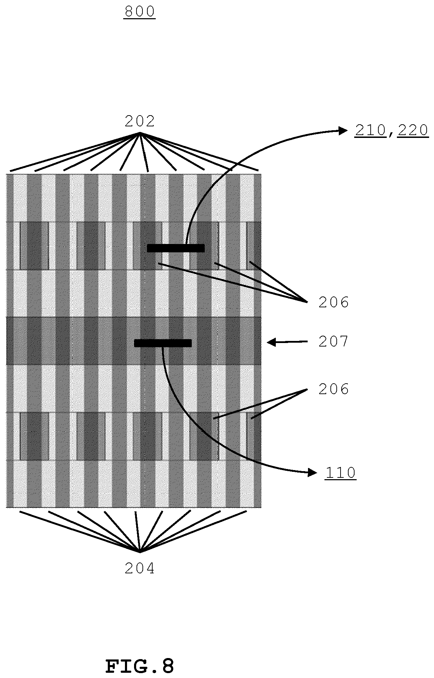

Fig. 8 is a top-view of another example embodiment of a semiconductor device 800 including a striped layout of alternating trench stripes 202 and SN stripes 204. Orthogonally to the trench stripes 202 and SN stripes 204, contact stripe regions 206, 207 may be arranged in an orthogonal direction on top of the trench stripes 202 and SN stripes 204. The semiconductor device 800 is partly similar to the semiconductor device 200 of Fig. 2 and partly similar to the semiconductor device 100 of Fig. 1. The arrangement of the non-continuous side-by-side orthogonally arranged contact stripe regions 206 are similar to that of Fig. 2. The arrangement of the continuous orthogonally arranged contact stripe region 207 is similar to the contact stripe region 206 of Fig. 1. The semiconductor device 700 may include a plurality of alternating side-by-side orthogonally arranged contact stripe regions 206 and contact stripe regions 207, wherein the side-by-side orthogonally arranged contact stripe regions 206 are aligned in the orthogonal direction, i.e., cover the same trench stripes 202 and SN stripes 204. The highlighted areas (black bars) indicates that the trenches at these locations may be realized such as the part of the trench MOSFET 210 or the part of the trench MOSFET 220 as shown in Fig. 2 or the part of the trench MOSFET 110 as shown in Fig. 1. The semiconductor device 400 includes trench MOSFETS 210, 220 in a single cell off-set flat contact arrangement with alternating orthogonal contact.

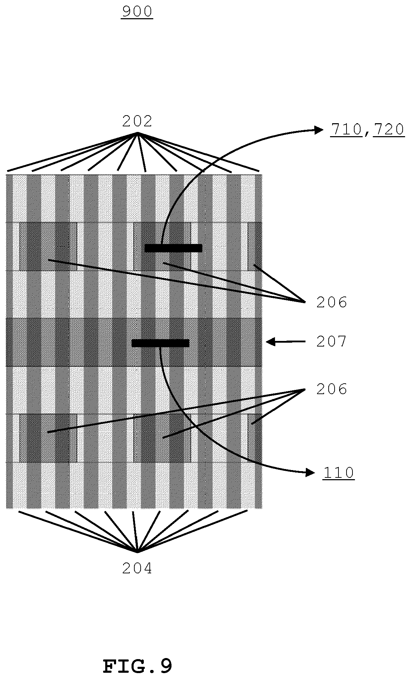

Fig. 9 is a top-view of another example embodiment of a semiconductor device 900 including a striped layout of alternating trench stripes 202 and SN stripes 204. Orthogonally to the trench stripes 202 and SN stripes 204, contact stripe regions 206, 207 may be arranged in an orthogonal direction on top of the trench stripes 202 and SN stripes 204. The semiconductor device 900 is partly similar to the semiconductor device 700 of Fig. 7A and partly similar to the semiconductor device 100 of Fig. 1. The arrangement of the non-continuous side-by-side orthogonally arranged contact stripe regions 206 are similar to that of Fig. 7A. The arrangement of the continuous orthogonally arranged contact stripe region 207 is similar to the contact stripe region 206 of Fig. 1. The semiconductor device 900 may include a plurality of alternating side-by-side orthogonally arranged contact stripe regions 206 and contact stripe regions 207, wherein the side-by-side orthogonally arranged contact stripe regions 206 are aligned in the orthogonal direction, i.e., cover the same trench stripes 202 and SN stripes 204. The highlighted areas (black bars) indicates that the trenches at these locations may be realized such as the part of the trench MOSFET 910 or the part of the trench MOSFET 920 as shown in Fig. 7B or the part of the trench MOSFET 110 as shown in Fig. 1. The semiconductor device 800 includes trench MOSFETS 710, 720 in a dual cell off-set flat contact arrangement with alternating orthogonal contact.

The solution of the present disclosure may be applied to any type of trench MOSFET, such as (but not limited to) shield gate MOSFETs, split gate MOSFETs, dual gate MOSFETs, split poly MOSFETs, high density MOSFETs, U-shape MOSFETs, dual electrode MOSFETs or multi electrode MOSFETs.

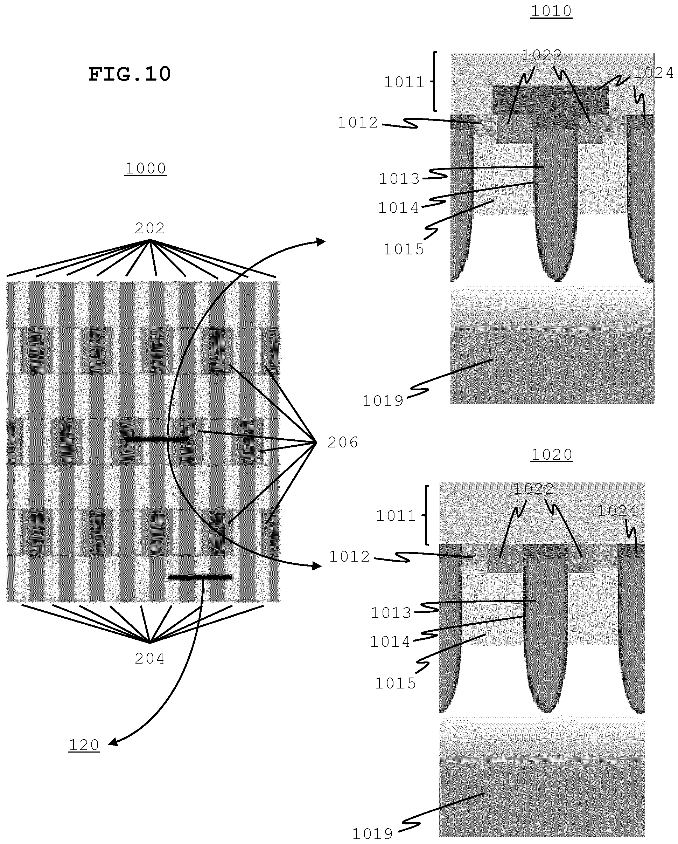

Fig. 10 shows example embodiments of U-shaped MOSFETs 1010, 1020. The U-shaped MOSFETs 1010, 1020 may be part of a semiconductor device 1000 including a striped layout of alternating trench stripes 202 and SN stripes 204, as shown in the top-down view of the semiconductor device 1000 in Fig. 10. This stiped layout is similar to the semiconductor device 200 of Fig. 2.

In the top-view of the semiconductor device 1000, two areas with trenches have been highlighted (black bars). The top area is shown in more detail on the right side of Fig. 10, where two variants 1010, 1020 of a part of the U-shaped MOSFET are shown. The bottom area may be similar to the part of the U-shaped MOSFET 120 as described with Fig. 1.

The part of the U-shaped MOSFET 1010, 1020 as shown in Fig. 10 includes three trenches 1013. Half of the left trench and half of the right trench are shown and a middle trench is shown in full. Each trench 1013 may include a gate poly, i.e., the part depicted 1013 surrounded by a liner oxide 1014. The trenches 1013 are formed in the semiconductor substrate 1019, such as epitaxy layers or an N++/N- substrate. Deeper parts of the trenches 1013 are separated by the substrate material 1019 while the upper parts of the trenches 1013 may be separated by a P doped body junction 1015 and two half pitch regions 1012, 1022.

The half pitch regions 1012, 1022 may include a half pitch P+ doped flat contact region 1012 and a half pitch N+ doped NP junction region 1022. The surface of the half pitch N+ doped NP junction region 1022 may be level with the half pitch flat contact region 1012.

An ILD 1024 may be deposited on top of the trenches 1013. In the example embodiment of the part of the U-shaped MOSFET 1010, the ILD 1024 may be deposited on top of the trenches having half pitch P+ doped flat contact regions 1012 on both sides of the trench, with the ILD being level with the half pitch P+ doped flat contact region 1012. In the U-shaped MOSFET 1010, the ILD 1024 may further be deposited on top of the trenches having half pitch N+ doped NP junction regions 1022 on both sides of the trench, the ILD 1024 covering the half pitch N+ doped NP junction regions 1022 and trench 1013 and extending above the surface of the half pitch N+ doped NP junction regions 1022.

In the example embodiment of the part of the U-shaped MOSFET 1020, the ILD 1024 may be deposited on top of the trenches 1013, with the ILD being level with the half pitch flat contact regions 1012 and the half pitch N+ doped NP junction regions 1022.

In both variants of the parts of the U-shaped MOSFET 1010, 1020, on top of the ILD 1024 top metal layers 1011 may be deposited allowing the semiconductor device to interconnect with, e.g., a contact stripe 206. In the example of Fig. 10, the metal layers 211 may include a layer of Silicide, e.g., TiSi, a layer of Tungsten (W) and/or a layer of AlCu. In the part of the U-shaped MOSFET 1010, the metal layer may be deposited to cover the half pitch flat contact regions 1012 and the ILD 1024.

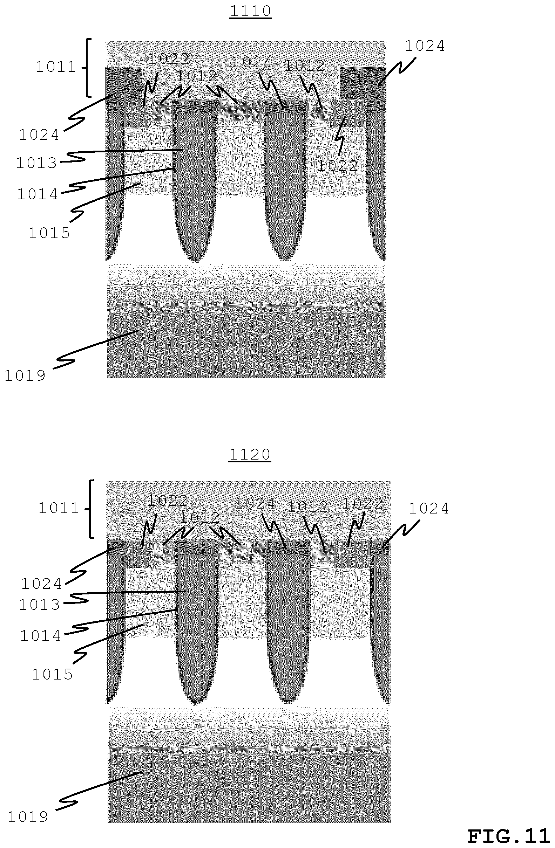

Fig. 11 shows another example embodiments of U-shaped MOSFETs 1110, 1120. The U-shaped MOSFETs 1110, 1120 may be part of a semiconductor device including a striped layout of alternating trench stripes 202 and SN stripes 204, such as shown in the top-down view of Fig. 7A.

In the top-view of Fig. 7A, one area with trenches has been highlighted (black bar) and is shown in more detail in Fig. 11 for U-shaped MOSFETs, where two variants 1110, 1120 of example embodiments of a part of the U-shaped MOSFET are shown.

The part of the U-shaped MOSFET 1110, 1120 as shown in Fig. 11 includes four trenches 1013. Half of the left trench and half of the right trench are shown and two trenches are shown in full. Each trench 1013 may include a gate poly, i.e. the part depicted 1013 surrounded by a liner oxide 1014. The trenches are formed in the semiconductor substrate 1019, such as epitaxy layers or an N++/N- substrate. Deeper parts of the trenches are separated by the substrate material 1019. The upper parts of two adjacent trenches may be separated by a P doped body junction 1015 and two half pitch regions 1012, 1022, i.e., a half pitch P+ doped flat contact region 1012 and a half pitch N+ doped NP junction region 1022, while the upper parts of two other adjacent trenches may be separated by a P doped body junction 1015 and a full pitch P+ doped flat contact region 1012. The surface of the half pitch N+ doped NP junction region 1022 may be level with the half pitch flat contact region 1012.

An ILD 1024 may be deposited on top of the trenches. In the example embodiment of the part of the U-shaped MOSFET of Fig/ 11, the ILD 1024 may be deposited on top of two adjacent trenches having half pitch P+ doped flat contact regions 1012 on one side of the trench and a full pitch P+ doped flat contact region 1012 in between the two trenches, with the ILD being level with the half pitch P+ doped flat contact region 1012. In the U-shaped MOSFET, the ILD 1024 may further be deposited on top of the trenches having half pitch N+ doped NP junction regions 1022 on both sides of the trench, the ILD 1024 covering the half pitch N+ doped NP junction regions 1022 and trench 1013 and extending above the surface of the half pitch N+ doped NP junction regions 1022.

In the U-shaped MOSFET 1120, the ILD 1024 may be deposited on top of the gate poly 1013 of the trenches, with the ILD being level with the half pitch flat contact regions 1012, the half pitch N+ doped NP junction regions 1022 and the full pitch flat contact regions 1012.

In both variants of the parts of the U-shaped MOSFET 1110, 1120, on top of the ILD 1024 top metal layers 1011 may be deposited allowing the semiconductor device to interconnect with, e.g., a contact stripe 206. In the example of Fig. 11, the metal layers 1011 may include a layer of Silicide, e.g., TiSi, a layer of Tungsten (W) and/or a layer of AlCu. In the part of the U-shaped MOSFET 1110, the metal layer may be deposited to cover the half pitch flat contact regions 1012 and the ILD 1024.

The semiconductor device of Fig. 11 includes U-shaped MOSFETS 1110, 1120 in a dual cell off-set flat contact arrangement. The half pitch structures 1012, 1022, i.e., half pitch P+ doped flat contact regions 1012 and the half pitch N+ doped NP junction regions 1022, in the semiconductor device of Fig. 11 further creates opportunity to optimize best possible solution with respect to RDSON and ruggedness.

The semiconductor device of the present disclosure may be used, e.g., for general purpose power MOSFETs, low RDSON trench MOSFETs (e.g., 20-150V), automotive applications, and etcetera.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A flat contact trench metal-oxide-semiconductor field-effect transistor, MOSFET (210, 220, 710, 720, 1010, 1020, 1110, 1120), comprising a plurality of trenches, wherein a mesa between two trenches comprises a half pitch P+ doped flat contact region (212, 1012) and a half pitch N+ doped NP junction region (222, 1022), and wherein a surface of the half pitch N+ doped NP junction region (222, 1022) is level with the half pitch flat contact region (212, 1012).

2. The flat contact trench MOSFET (210, 1010) according to claim 1,
wherein an inter layer dielectric, ILD (224, 1024), is arranged on top of the trenches,
wherein the ILD (224, 1024) is partly arranged on top of a trench having half pitch P+ doped flat contact regions (212, 1012) on both sides of the trench with the ILD (224, 1024) being level with the half pitch P+ doped flat contact region (212, 1012),
and wherein the ILD (224, 1024) is partly arranged on top of another trench having half pitch N+ doped NP junction regions (222, 1022) on both sides of the other trench with the ILD (224, 1024) covering the half pitch N+ doped NP junction regions (222, 1022) and a gate poly (213, 1013) of the other trench and extending above the surface of the half pitch N+ doped NP junction regions (222, 1022).

3. The flat contact trench MOSFET (220, 1020) according to claim 1,
wherein an inter layer dielectric, ILD (224, 1024), is arranged on top of the trenches,
and wherein the ILD (224, 1024) is arranged on top of the gate polys (213, 1013) of the trenches with the ILD (224, 1024) being level with the half pitch flat contact regions (212, 1012) and the half pitch N+ doped NP junction regions (222, 1022).

4. The flat contact trench MOSFET (710, 1110) according to claim 1,
wherein an inter layer dielectric, ILD (224, 1024), is arranged on top of the trenches,
wherein the ILD (224, 1024) is partly arranged on top of two adjacent trenches having half pitch P+ doped flat contact regions (212, 1012) on one side and a full pitch P+ doped flat contact region (212, 1012) in between the two adjacent trenches,
and wherein the ILD (224, 1024) is partly arranged on top of another trench having a half pitch N+ doped NP junction region (222, 1022) on at least one side of the other trench with the ILD (224, 1024) covering the half pitch N+ doped NP junction region (222, 1022) and a gate poly (213, 1013) of the other trench and extending above the surface of the half pitch N+ doped NP junction regions (222, 1022).

5. The flat contact trench MOSFET (720, 1120) according to claim 1,
wherein an inter layer dielectric, ILD (224, 1024), is arranged on top of the trenches,
wherein two adjacent trenches have half pitch P+ doped flat contact regions (212, 1012) on one side and a full pitch P+ doped flat contact region (212, 1012) in between the two adjacent trenches,
and wherein the ILD (224, 1024) is arranged on top of the gate polys (213, 1013) of the trenches with the ILD (224, 1024) being level with the half pitch flat contact regions (212, 1012) and the half pitch N+ doped NP junction regions (222, 1022).

6. The flat contact trench MOSFET (210, 220, 710, 720, 1010, 1020, 1110, 1120) according to any one of the claims 3-5, wherein, on top of the ILD (224, 1024) one or more top metal layers (211, 1011) are arranged, the one or more top metal layers (211, 1011) preferably including one or more of a layer of Silicide, a layer of Tungsten and a layer of Aluminum-Copper alloy, AICu.

7. The flat contact trench MOSFET (210, 220, 710, 720, 1010, 1020, 1110, 1120) according to any one of the preceding claims,
wherein a trench is formed in a semiconductor substrate and comprises one or more of a gate poly (213, 1013), a gate oxide (214), an inter poly oxide, IPO 216, a source poly (217) and a liner oxide (218, 1014),
wherein deeper parts of the trench (216, 217, 218) are separated by the semiconductor substrate (219, 1019),
and wherein upper parts of the trench (213, 214) are separated by a P doped body junction (215, 1015), the half pitch N+ doped NP junction region (222, 1022) and the half pitch flat contact region (212, 1012).

8. A semiconductor device (200, 400, 500, 600, 700, 800, 900) comprising a plurality of flat contact trench MOSFETs (210, 220, 710, 720, 1010, 1020, 1110, 1120) according to any one of the claims 1-7.

9. The semiconductor device (200) according to claim 8, comprising:
a striped layout of alternating trench stripes (202) and source N-type region, SN, stripes (204); and
contact stripe regions (206) that are arranged orthogonally to the trench stripes (202) and the SN stripes (204) in an orthogonal direction on top of the trench stripes (202) and SN stripes (204),
wherein the contact stripe regions (206) are arranged such that one contact stripe region (206) covers a trench stripe (202) and about half of two SN stripes (204) directly adjacent to the covered trench stripe (202),
wherein a plurality of contact stripe regions (206) are arranged side-by-side in the orthogonal direction and divided by in between regions without contact stripe regions, wherein the contact stripe regions (206) and the in between regions have a similar width in the orthogonal direction,
wherein the semiconductor device (200) comprises a plurality of side-by-side orthogonally arranged contact stripe regions,
wherein two neighboring side-by-side orthogonally arranged contact stripe regions are offset in the orthogonal direction by a distance equal to the width of a contact stripe region (206),
and wherein neighboring side-by-side contact stripe regions are spaced apart in the direction of the trench stripes (202) and SN stripes (204).

10. The semiconductor device (400) according to claim 8, comprising:
a striped layout of alternating trench stripes (202) and source N-type region, SN, stripes (204); and
contact stripe regions (206) that are arranged orthogonally to the trench stripes (202) and the SN stripes (204) and in an orthogonal direction on top of the trench stripes (202) and SN stripes (204),
wherein the contact stripe regions (206) are arranged such that one contact stripe region (206) covers a trench stripe (202) and about half of two SN stripes (204) directly adjacent to the covered trench stripe (202),
wherein a plurality of contact stripe regions (206) are arranged side-by-side in the orthogonal direction and divided by in between regions without contact stripe regions, wherein the contact stripe regions (206) and the in between regions have a similar width in the orthogonal direction,
wherein the semiconductor device (200) comprises a plurality of side-by-side orthogonally arranged contact stripe regions,
wherein two neighboring side-by-side orthogonally arranged contact stripe regions are aligned in the orthogonal direction,
and wherein neighboring side-by-side contact stripe regions are spaced apart in the direction of the trench stripes (202) and SN stripes (204).

11. The semiconductor device (500) according to claim 8, comprising:
a striped layout of alternating trench stripes (202) and source N-type region, SN, stripes (204); and
contact stripe regions (206) that are arranged in the same direction as the trench stripes (202) and the SN stripes (204) on top of the trench stripes (202) and SN stripes (204),
wherein the contact stripe regions (206) are arranged such that one contact stripe region (206) covers a trench stripe (202) and about half of two SN stripes (204) directly adjacent to the covered trench stripe (202),
and wherein a plurality of contact stripe regions (206) are arranged side-by-side and are divided by in between regions without contact stripe regions, wherein the contact stripe regions (206) and the in between regions have a similar width.

12. The semiconductor device (600) according to claim 8, comprising:
a striped layout of alternating trench stripes (202) and source N-type region, SN, stripes (204); and
contact stripe regions (206) that are arranged in the same direction as the trench stripes (202) and the SN stripes (204) on top of the trench stripes (202) and SN stripes (204),
wherein the contact stripe regions (206) are arranged such that one contact stripe region (206) covers about half of a trench stripe (202) and about half of one SN stripe (204) directly adjacent to the covered trench stripe (202),
and wherein a plurality of contact stripe regions (206) are arranged side-by-side and are divided by in between regions without contact stripe regions, wherein the contact stripe regions (206) and the in between regions have a similar width.

13. The semiconductor device (700) according to claim 8, comprising:
a striped layout of alternating trench stripes (202) and source N-type region, SN, stripes (204); and
contact stripe regions (206) that are arranged orthogonally to the trench stripes (202) and the SN stripes (204) in an orthogonal direction on top of the trench stripes (202) and SN stripes (204),
wherein the contact stripe regions (206) are arranged such that one contact stripe region (206) covers two trench stripes (202), one intermediate SN stripe (204) and about half of two SN stripes (204) directly adjacent to the covered trench stripes (202),
wherein a plurality of contact stripe regions (206) are arranged side-by-side in the orthogonal direction and are divided by in between regions without contact stripe regions, wherein the contact stripe regions (206) and the in between regions have a similar width in the orthogonal direction,
wherein the semiconductor device (700) comprises a plurality of side-by-side orthogonally arranged contact stripe regions,
wherein two neighboring side-by-side orthogonally arranged contact stripe regions are offset in the orthogonal direction by a distance equal to the width of a contact stripe region (206),
and wherein neighboring side-by-side contact stripe regions are spaced apart in the direction of the trench stripes (202) and SN stripes (204).

14. A process (300) of manufacturing a semiconductor device (200, 400, 500, 600, 700, 800, 900) according to any one of the claims 8-13, the process comprising:
creating (301-309) a plurality of trenches in an epitaxial layer (320);
forming (311), in a mesa between two trenches, a body region (338) and a source region (340) by implant and diffusion in presence of a mask using half of a pitch width to form the source region (340) in half of the mesa; and
etching (313) an inter layer dielectric, ILD (342), in the direction of a silicon surface, the etching being performed in presence of a further mask using half of the pitch width to expose the other half of the mesa;
forming a flat contact region (348) in the other half of the mesa by implanting the other half of the mesa.

15. The process according to claim 14, further comprising, before forming (110) the body region and the source region, creating a gate recess (336) further below a silicon surface, wherein preferably a depth of the gate recess (336) is twice or more than twice the thickness of a gate oxide (332) of a trench.
